**Europäisches Patentamt**

**European Patent Office**

**Office européen des brevets.**

(19)

(11) Veröffentlichungsnummer: **0 154 909**
**A2**

(12) EUROPÄISCHE PATENTANMELDUNG

(21) Anmeldenummer: **85102330.9**

(22) Anmeldetag: **01.03.85**

(51) Int. Cl.⁴: **H 05 K 3/42**

(30) Priorität: **09.03.84 DE 3408630**

(71) Anmelder: **HOECHST AKTIENGESELLSCHAFT,
Postfach 80 03 20, D-6230 Frankfurt am Main 80 (DE)**

(43) Veröffentlichungstag der Anmeldung: **18.09.85
Patentblatt 85/38**

(84) Benannte Vertragsstaaten: **DE FR GB**

(72) Erfinder: **Seibel, Markus, Dr. Dipl.-Chem., Am
Rosengarten Nr. 16, D-6500 Mainz 1 (DE)**

(54) Verfahren und Schichtmaterial zur Herstellung durchkontaktierter elektrischer Leiterplatten.

(57) Es wird ein Verfahren zur Herstellung von durchkontaktierten elektrischen Leiterplatten beschrieben, bei dem eine Platte aus Isolierstoffmaterial mit in rasterartigem Muster angeordneten Durchkontaktierungslöchern versehen wird, deren Wandungen mit einer Metallschicht überzogen werden und die auf mindestens einer Seite mit einer leitfähigen Metallschicht bedeckt wird. Die Metallschicht wird nach dem Metallisieren der Löcher bildmässig abgedeckt, und die nicht abgedeckten Bereiche der Metallschicht werden entweder durch Metallablagerung verstärkt oder durch Ätzen entfernt. Zugleich mit der Metallschicht wird ein Teil der Löcher in der Weise abgedeckt, dass im fertigen Produkt nur der gewünschte Anteil aller Löcher als Leitkontakt wirksam wird. Das Verfahren erlaubt die Fertigung von vorgebohrtem bzw. vorgelochtem und vormetallisiertem Basismaterial für gedruckte Schaltungen in Grosserie.

ACTORUM AG

HOECHST AKTIENGESELLSCHAFT
KALLE  Niederlassung der Hoechst AG

84/K 019                    - 1 -          WLK-Dr.N.-ur
                                           28. Februar 1985


Verfahren und Schichtmaterial zur Herstellung durchkontaktierter elektrischer Leiterplatten


Die Erfindung betrifft ein Verfahren zur Herstellung durchkontaktierter elektrischer Leiterplatten unter Verwendung eines Schichtmaterials, das aus mindestens einer platten- oder bandförmigen Lage aus Isoliermaterial und mindestens einer elektrisch leitfähigen Metallschicht besteht und eine Vielzahl von Durchkontaktierungsbohrungen aufweist.

Es ist bekannt, Leiterplatten für gedruckte Schaltungen aus einem Schichtmaterial herzustellen, das aus einer Isolierplatte, z. B. aus glasfaserverstärktem Phenolharz, und einer damit verbundenen dünnen Kupferschicht besteht. Dabei wird die Kupferschicht mit einer Schablone, die der Anordnung der gewünschten Leiterzüge entspricht, abgedeckt und das nicht abgedeckte Kupfer durch Ätzen entfernt. Dieser als subtraktives Verfahren bezeichneten Arbeitsweise steht das additive Verfahren gegenüber, bei dem die Oberfläche der Isolierstoffplatte mit Edelmetallkeimen versehen und bildmäßig abgedeckt wird. Danach wird die nicht abgedeckte Oberfläche chemisch und ggf. galvanisch metallisiert. Auch ist ein semiadditives Verfahren gebräuchlich, bei dem zunächst eine durchgehende dünne Leitkupferschicht abgeschieden, dann die Abdeckschablone aufgebracht wird, die freiliegenden Stellen galvanisch verstärkt werden, die Schablone abgelöst wird und die freigelegten Bereiche der unverstärkten Kupferschicht fortgeätzt werden (vgl.

HOECHST AKTIENGESELLSCHAFT
KALLE Niederlassung der Hoechst AG

- 2 -

Herrmann, Handbuch der Leiterplattentechnik, Eugen
G. Leuze Verlag, Saulgau, Bundesrepublik Deutschland,
2. Auflage 1982).

Bisher werden die Löcher für die Durchkontaktierung nur in der Größe und Zahl, in der sie benötigt werden, also nur an den Stellen, wo sie gebraucht werden, durch Bohren oder Stanzen der Platten hergestellt. Danach werden die Lochwandungen durch eine erste, stromlose Metallabscheidung leitfähig gemacht.

Diese beiden Verfahrenschritte - das Bohren oder Stanzen der Löcher und das Durchmetallisieren - werden nach den heute bekannten und üblichen Verfahren erst in einer relativ späten Stufe der Leiterplattenherstellung durchgeführt, nämlich erst dann, wenn das dem gewünschten Schaltplan entsprechende Leiterzugmuster erzeugt wird. Da dieses für die meisten Leiterplattentypen individuell gemacht wird, sind die Stückzahlen von gleichen Platten mit gleicher Lochanordnung vergleichsweise klein; die Fertigung wird dadurch teuer.

Bei den bekannten Verfahren stellt die Herstellung der Löcher und die Metallisierung der Lochwandungen eine kritische Verfahrensstufe dar, die als Vorbereitung eine Reihe von Aufschluß- und Reinigungsschritten erfordert und mit besonderer Sorgfalt ausgeführt werden muß, um eine gleichmäßige, ununterbrochene Metallschicht zu erhalten. Sie ist beim subtraktiven und semiadditiven

HOECHST AKTIENGESELLSCHAFT
KALLE Niederlassung der Hoechst AG

- 3 -

Verfahren die einzige Stufe, bei der Metall stromlos abgeschieden werden muß.

Es ist bekannt, das isolierende Basismaterial durchgehend zu katalysieren, d. h. in seiner gesamten Masse mit Palladiumkeimen auszurüsten. Es ist dann möglich, die Kontaktierungslöcher an beliebige Stellen zu setzen und stromlos mit einem leitfähigen Metallüberzug zu versehen. Hierbei wird zwar im Anwendungsstadium der kritische Schritt der Metallbekeimung und der Verankerung der Keime eingespart, das Bohren und die stromlose Metallisierung müssen jedoch immer noch in diesem Stadium des Verfahrens erfolgen. Auch ist ein wesentlich höherer Aufwand an Edelmetallverbindungen für die Ausrüstung der gesamten Masse des Basismaterials erforderlich.

Aus der DE-A 24 53 788 ist ein Verfahren zur Herstellung von gedruckten Schaltungen bekannt, bei dem ein Leiterplattenbasismaterial verwendet wird, das einen Metallkern aufweist, der beidseitig mit Isolierschichten bedeckt ist, auf die jeweils ein Stromkreisschaltbild aus Kupfer aufgebracht wird. Zur Herstellung der Durchkontaktierungen sind an den gewünschten Stellen Löcher in dem Laminat vorgesehen, die mit Pfropfen aus isolierendem Kunststoff ausgefüllt sind. Durch diese Pfropfen werden dann engere Löcher in der Weise gebohrt, daß eine durchgehende Wandung aus dem isolierenden Kunststoff zurückbleibt. Diese Wandungen werden dann mit einer leitfähigen Metallschicht überzogen, die den Kontakt zwischen beiden Oberflächen herstellt, ohne daß ein leitender Kontakt zu dem Metallkern entsteht.

Ein ähnliches Verfahren beschreibt die DE-B 27 39 494. Hier werden in dem Basismaterial Löcher in einer die Zahl der später gewünschten Durchkontaktierungen übersteigenden Anzahl, z. B. in Rasteranordnung, erzeugt und mit Isolierstoff ausgefüllt. Später werden bei der Leiterplattenfertigung nur an den benötigten Stellen die Isolierstoffpfropfen wieder ausgebohrt und die so erzeugten Bohrungen metallisiert. Durch die Anordnung der Bohrungen im Raster soll bei Leiterplatten für die Digitalelektronik mit mehreren integrierten Schaltkreisen eine einheitliche Serienfertigung des Basismaterials ermöglicht werden.

Bei allen diesen Verfahren kann aber die Durchkontaktierung der Bohrungen erst bei der Herstellung der gedruckten Schaltung individuell entsprechend dem gewünschten Schaltplan hergestellt werden. Das bedeutet, daß die kritische Metallisierung der Lochwandungen mit ihrer vielstufigen Vorbereitung und Metallabscheidung stets den technologischen Nachteilen der Einzelfertigung bzw. der Kleinserie beim Verarbeiter des Basismaterials unterworfen ist.

Aufgabe der Erfindung war es, ein Verfahren zur Herstellung durchkontaktierter Leiterplatten vorzuschlagen, das es erlaubt, die kritischen Stufen der Herstellung der

HOECHST AKTIENGESELLSCHAFT
KALLE Niederlassung der Hoechst AG

- 5 -

Löcher für die Durchkontaktierung sowie die Vorbereitung, Reinigung, Impfung und stromlose Metallisierung bis zur Erzeugung einer durchgehenden Metallschicht, insbesondere in den Löchern des Isoliermaterials, fabrikmäßig in Großserie und damit kostengünstig durchzuführen und ein Trägermaterial zur Fertigung von Leiterplatten bereitzustellen, das dennoch im Stadium der Herstellung der Schaltungen eine weitgehende Variation bei der Ausgestaltung der Leiterzüge und Kontaktierungen erlaubt.

Erfindungsgemäß wird ein Verfahren zur Herstellung von durchkontaktierten elektrischen Leiterplatten vorgeschlagen, bei dem eine Platte, ein Band oder eine Schicht aus Isolierstoffmaterial mit Durchkontaktierungslöchern, deren Wandungen mit leitfähigem Metall überzogen sind, auf mindestens einer Seite mit einer leitfähigen Metallschicht versehen wird, die Metallschicht bildmäßig abgedeckt wird und die nicht abgedeckten Bereiche der Metallschicht entweder durch Metallablagerung verstärkt oder durch Ätzen entfernt werden, wobei im Fall der Metallablagerung die Abdeckschablone anschließend entfernt wird und die nicht verstärkten Anteile der Metallschicht durch Ätzen entfernt werden.

Das erfindungsgemäße Verfahren ist dadurch gekennzeichnet, daß man die Löcher in einem regelmäßigen Muster über die Oberfläche der Platte verteilt anbringt, ihre Wandungen vor dem bildmäßigen Abdecken der Metallschicht metallisiert und die Metallschicht und einen Teil der Löcher in der Weise abdeckt, daß im fertigen Produkt nur der gewünschte Anteil aller Löcher als Leitkontakt wirksam wird.

Erfindungsgemäß wird ferner ein Schichtmaterial zur Herstellung durchkontaktierter elektrischer Leiterplatten vorgeschlagen, das aus mindestens einer Lage aus Isoliermaterial und mindestens einer ununterbrochenen leitfähigen Metallschicht besteht und eine Vielzahl von Durchkontaktierungslöchern aufweist.

Das erfindungsgemäße Schichtmaterial ist dadurch gekennzeichnet, daß die Durchkontaktierungslöcher in einem regelmäßigen Muster über die Fläche des Schichtmaterials verteilt und an ihren Innenwänden mit leitendem Metall überzogen sind.

Durch die z. B. mit Hilfe von Computern ermittelte und erstellte Anordnung von vorgelochten, durchkontaktierten Abschnitten neben ungelochten Flächen ist es möglich, einheitliche Lochmuster vorzufertigen, die für zahlreiche unterschiedliche Schaltungen einsetzbar sind. Damit lassen sich die Kosten der Leiterplattenherstellung ganz erheblich senken.

Bei dem erfindungsgemäßen Verfahren können die verschiedensten isolierenden Substrate, auf denen leitende Schaltungsmuster herstellbar sind, zum Einsatz gelangen. So kann man als isolierendes Substrat eine Kunststoffplatte, eine keramische Platte oder ein durch Wärmepressen übereinanderliegender Lagen, die durch Imprägnieren einer Unterlage aus beispielsweise Glasfasern oder Papier mit einem wärmehärtbaren Harz hergestellt wurden, erhaltenes Verbundgebilde verwenden. Ferner kann man das isolierende Substrat herstellen, indem die Oberfläche einer Metallplatte mit einer isolierenden Schicht versehen wird. Kurz gesagt, es braucht nicht das gesamte Substrat aus einem isolierenden Material zu bestehen; vielmehr reicht es aus, wenn mindestens der Oberflächenbereich des Substrats isolierende Eigenschaften aufweist.

Auf der Oberfläche des isolierenden Substrats wird eine Schicht aus einem Harzklebstoff ausgebildet. Verwendbare Klebstoffe sind synthetische Dienkautschuke und kautschukfreie Klebstoffe. Beispiele für verwendbare synthetische Dienkautschuke sind Butadienpolymerisate, Butadien/Acrylnitril-Mischpolymerisate, Isoprenkautschuk, Chloroprenkautschuk, Acrylnitril/Butadien/Styrol-Terpolymerisate und Mischungen aus mindestens zwei der genannten synthetischen Kautschuke. Dem synthetischen Kautschuk, beispielsweise einem Kautschuk der angegebenen Art, kann auch ein wärmehärtbares Harz, z. B. ein Epoxy- oder Phenolharz, zugesetzt werden. Der den synthetischen Dienkautschuk enthaltende oder aus diesem bestehende Klebstoff gestattet die spätere feste Bindung einer leitenden Schicht an das Substrat. Wenn ein wärmehärtbares Harz mitverwendet wird, sollte der synthetische Dienkautschuk in einer solchen Menge zum Einsatz gelangen, daß sein Gewicht, bezogen auf die Gesamtmenge an synthetischem Dienkautschuk und wärmehärtbarem Harz, etwa 10 bis 70 Gew.-%, vorzugsweise etwa 50 Gew.-%, beträgt.

Abgesehen von den synthetischen Kautschuken können als Klebstoffe beispielsweise Epoxyharze, wie Epoxyharze vom Bisphenoltyp, Epoxy/Novolak-Harze, alicyclische Epoxyharze und deren Gemische zum Einsatz gelangen. Diese Epoxyharze gestatten die Herstellung gedruckter Schaltungsplatinen hervorragender elektrischer Eigenschaften.

Die verwendbaren Klebstoffe der genannten Arten können anorganische Füllstoffe, wie Silikagel, Zirkoniumsilikat oder Magnesiumsilikat, die als Verstärkungsmaterial wirken, enthalten. Bezogen auf die Gesamtmenge Harz darf die Menge an anorganischem Füllstoff 3 bis 50 % betragen. Wenn die Klebemasse ein wärmehärtbares Harz enthält, kann ihr zusätzlich ein Härtungsmittel, z. B. ein Amin oder Säureanhydrid, einverleibt werden. Ferner kann der Klebemasse ein Pigment zugesetzt werden.

Die Klebstoffschicht wird mit einem Oxidationsmittel behandelt, um sie für die folgenden Metallisiermaßnahmen aufnahmefähig zu machen. Insbesondere dient die Behandlung mit dem Oxidationsmittel dazu, die Klebstoffschichtoberfläche aufzurauhen, da sie geätzt wird. Darüber hinaus wird die Klebstoffschicht hydrophil gemacht. Verwendbare Oxidationsmittel sind beispielsweise Chromsäure, Salze der Chromsäure, Permanganat, Chromsäure/Fluorborsäure-Gemische, Chromsäure/Schwefelsäure-Gemische. Insbesondere Gemische aus Chromsäure und Schwefelsäure

HOECHST AKTIENGESELLSCHAFT
KALLE  Niederlassung der Hoechst AG

- 9 -

ermöglichen es, daß das später gebildete leitende Schaltungsmuster fest an die Klebstoffschicht gebunden wird.

Nach der Behandlung mit dem Oxidationsmittel wird die Klebstoffschichtoberfläche aktiviert, damit bei der folgenden stromlosen Metallisierung eine Metallablagerung erfolgen kann. Insbesondere wird das bei der stromlosen Metallisierung als Katalysator oder Aktivierungsmittel wirkende Palladium zu Aktivierungszwecken auf der Klebstoffschichtoberfläche abgelagert. Die Aktivierungsbehandlung erfolgt beispielsweise durch Eintauchen des Substrats in eine Palladiumchlorid und Zinn(II)-chlorid enthaltende und mit Salzsäure angesäuerte Lösung. Ferner ist es möglich, die Substratoberfläche mit einer mit Salzsäure angesäuerten Zinn(II)-chloridlösung und danach mit einer Palladiumchloridlösung in Berührung zu bringen. Andererseits kann die Substratoberfläche auch mit einer Lösung eines organischen Palladiumkomplexes in Berührung gebracht und danach mit einem schwachen Reduktionsmittel behandelt werden, um auf der Klebstoffschichtoberfläche metallisches Palladium abzulagern. Das abgelagerte Palladium, d. h. der Katalysator, ermöglicht eine ausreichende Ablagerung des gewünschten Metalls bei der folgenden stromlosen Metallisierung.

Schließlich wird die Substratoberfläche einer stromlosen Metallisierung unterworfen. Verwendbare Bäder sind beispielsweise Kupfer-, Nickel- oder Goldbäder. Besonders gut geeignet ist ein Kupferbad zur stromlosen Verkupferung mit beispielsweise Kupfersulfat, Ethylendiamintetraacetat oder Rochellesalz und Formaldehyd. Erforderlichenfalls können dem Bad Natriumhydroxid, Dipyridyl, Polyethylenoxid und dergleichen zugesetzt werden. In der Regel wird das Bad auf einer Temperatur von 50° bis 78°C gehalten. Während des stromlosen Metallisierens wird der pH-Wert des Bads auf etwa 12,0 bis 13,0 eingestellt.

Bei dem erfindungsgemäßen Verfahren werden bevorzugt beide Seiten des Isolierstoffmaterials mit einer leitfähigen Metallschicht, insbesondere einer Kupferschicht, überzogen. Die Dicke der Metallschicht richtet sich nach der beabsichtigten Weiterverarbeitung. Wenn diese nach dem semiadditiven Verfahren erfolgt, muß die Schicht so beschaffen sein, daß sie in sich zusammenhängend ist und den stromlosen oder bevorzugt galvanischen Aufbau von homogenen und fehlerfreien Metallschichten jeder gewünschten Stärke erlaubt. Im allgemeinen sind hierfür Schichtdicken von etwa 0,1 bis 5/um, bevorzugt 0,2 bis 3/um, ausreichend.

Wenn die Weiterverarbeitung durch den Leiterplattenhersteller subtraktiv erfolgen soll, kann die Schichtdicke im allgemeinen 5 - 100/um, vorzugsweise 10 - 70/um, betragen.

Insbesondere bei hohen Schichtdicken ist es erfindungsgemäß auch möglich, von ein- oder beidseitig kupferkaschiertem Basismaterial auszugehen, dieses mit Löchern zu versehen und dann die Lochwandungen zu verkupfern, wobei auch zugleich die Schichten verstärkt werden können.

Besonders vorteilhaft ist die Kombination des erfindungsgemäßen Verfahrens mit der semiadditiven oder der subtraktiven Arbeitsweise.

Es ist zweckmäßig, die Oberfläche des Isoliermaterials nach dem Bohren bzw. Stanzen der Löcher in bekannter Weise durch Reinigen, Anätzen, Bekeimen usw. für die chemische und ggf. galvanische Metallisierung vorzubereiten, da sich zu diesem Zeitpunkt die genannten Schritte in rationeller Weise durchführen lassen. Die Durchführung erfolgt in bekannter Weise durch Erzeugen von fest haftenden Edelmetall-, z. B. Palladium- oder Silberkeimen, wie es z. B. in der DE-A 16 96 603 und der US-A 3 632 388 beschrieben ist, an denen dann stromlos eine zusammenhängende Metallschicht abgeschieden wird.

Das erfindungsgemäße Schichtmaterial wird nach seiner Produktion durch den Hersteller zweckmäßig in Form von Großformaten oder Rollen an den Leiterplattenhersteller geliefert und von diesem weiterverarbeitet. Dabei wird in bekannter Weise die Metall-, insbesondere Kupferschicht mit einer Schablone abgedeckt, die dem Aufbau des gewünschten Schaltungsmusters entspricht. Die Schablone kann in bekannter Weise im Siebdruck oder nach dem Photoresistverfahren aufgebracht werden. Dabei ist es zweckmäßig, ein Verfahren zu wählen, mit dem sich die

HOECHST AKTIENGESELLSCHAFT
KALLE Niederlassung der Hoechst AG

- 12 -

Löcher vollständig überdecken lassen. Für diese als Tenting-Technik bezeichnete Arbeitsweise ist z.B. ein Trocken-Photoresist geeignet.

Die Trockenresistschicht wird auf die Kupferschicht laminiert, wobei alle Löcher überdeckt werden. Danach wird die Resistschicht unter einem Schaltbild belichtet, das die gewünschten Leiterzüge und die benötigten Durchkontaktierungslöcher wiedergibt. Nach dem Belichten wird die Resistschicht zur Schablone entwickelt und das freigelegte Kupfer geätzt (subtraktiv) oder galvanisch verstärkt und ggf. noch galvanisch mit Blei-Zinn-Legierung überzogen (semiadditives Verfahren). Die Resistschablone wird durch Entschichten entfernt, und - beim semiadditiven Verfahren - das Basiskupfer wird auf der Oberfläche auch in den Löchern weggeätzt. Dabei ist es nicht erforderlich, das gesamte Basiskupfer zu entfernen. Es reicht aus, wenn die nicht benötigten Flächen des Basiskupfers durch Ätzen eines Zwischenraums von den Leiterzügen und Durchkontaktierungen getrennt werden. Das kann zweckmäßig wieder durch Abdecken mit einer geeigneten Photoresistschablone erfolgen. Es ist auch möglich, diese Trennung von Leiterflächen und "Blindflächen" vor dem Galvanisieren durchzuführen und danach auch die Blindflächen galvanisch zu verstärken. Diese Variante hat den Vorteil, daß die zusätzliche Metallbelegung eine bessere Wärmeableitung bei nachfolgenden Behandlungsstufen, z. B. beim Löten, bewirkt. Die Wärmeableitung ist besonders effektiv, wenn ein Isoliermaterial mit einem Metallkern verwendet wird. Auch hat das beschriebene "Trennätzen" den Vorteil, daß beim Verarbeiten wesentlich geringere Mengen an Kupferionen enthaltenden verbrauchten Ätzbädern anfallen. Die Belichtung unter der Vorlage hat passergenau im Hinblick auf die Lage der Löcher zu erfolgen. Das kann z. B. durch Anbringen von Markierungen am Rand der Platte und Ansteuern der Löcher, ausgehend von diesen Markierungen, erfolgen.

Das erfindungsgemäße Verfahren hat den Vorteil, daß eine Reihe von kritischen, zeitraubenden und umweltbelastenden Verfahrensschritten vom Hersteller der Leiterplatten, d. h. von der Einzelverarbeitung von Platten im endgültigen Formatzuschnitt, zum Hersteller des Leiterplattenrohmaterials, d. h. in die Großserienfertigung verlagert wird. Hierdurch ist eine rationellere Fertigung von qualitativ besseren und einheitlicheren metallbeschichteten Basismaterialien möglich. Auch ist die Entsorgung von verbrauchten Bädern und Reinigungslösungen einfacher und sicherer.

Für den Anwender der neuen metallbeschichteten Basismaterialien bleiben nur wenige Ätz- oder Galvanisierstufen, die sich leicht beherrschen lassen und bei denen nur ein Bruchteil an verbrauchten Bädern anfällt.

Mit dem vorgefertigten Basismaterial lassen sich auf einfache Weise eine Vielzahl unterschiedlicher Leiterplattenarten auch in Kleinserien herstellen.

- 14 -

Die folgenden Beispiele erläutern bevorzugte Ausführungsformen der Erfindung.

## Beispiel 1

Eine 2 mm dicke Platte aus glasfaserverstärktem Epoxidharz
wird mit einer handelsüblichen Haftvermittlerschicht überzogen und diese dann ausgehärtet. Danach werden regelmäßig
angeordnete Löcher von 1 mm Durchmesser im gegenseitigen
Abstand von 2,5 mm eingebohrt. An den Kanten der Platte
werden Markierungen, z. B. Pilotlöcher, die der Lage der
Lochreihen entsprechen, als Bezugspunkte zum Ansteuern
der Löcher angebracht.

Die Plattenoberfläche wird dann mit Chromschwefelsäure
angeätzt, gereinigt, entgiftet und neutralisiert, mit
Palladiumchloridlösung sensibilisiert und mit Zinn-IIchloridlösung aktiviert. An den so erzeugten Palladiumkeimen wird aus einem üblichen stromlosen Kupferbad
eine Kupferschicht von ca. 0,3 $\mu$m Dicke abgeschieden.
Die Platte kann in dieser Form gelagert und zum Verarbeiter transportiert werden.

Zur Herstellung einer Leiterplatte wird auf beide Seiten
der Platte eine Negativ-Trockenresistfolie mittels eines
handelsüblichen Laminators aufgebracht. Jede Trockenresistschicht wird wie üblich unter einem Positiv eines
Schaltbilds belichtet, die Trägerfolien werden von der
Resistschicht abgezogen und die Schichten mit einer
wäßrig-alkalischen Lösung entwickelt, wobei die unbelichteten Schichtbereiche ausgewaschen werden. An den freigelegten Leiterzügen und Löchern wird dann in einem handelsüblichen Kupferbad die Kupferschicht galvanisch auf ungefähr 50 µm verstärkt. Dann wird mit einem handelsüblichen Blei-Zinn-Bad auf dem Kupfer eine etwa 10 µm dicke Lage Blei-Zinn-Legierung galvanisch abgeschieden. Die Resistschablone wird entfernt und das darunter freigelegte Basiskupfer fortgeätzt.

## Beispiel 2

Eine 0,5 mm dicke Aluminiumplatte wird mit einem Lochraster durch Einstanzen der Löcher versehen. Die Löcher haben einen Durchmesser von 1 mm und einen gegenseitigen Abstand von 2,5 mm (Lochrand zu Lochrand). Die durch das Stanzen entstandenen Grate werden durch Bürsten und die Rückstände des beim Stanzen verwendeten Öls durch Abwaschen mit einem Lösungsmittel entfernt.

Die Platte wird nun mit einer alkalischen Lösung gebeizt, elektrolytisch aufgerauht und durch anodische Oxydation mit einer Oxidschicht von 4 $g/m^2$ versehen. Die Oxidschicht wird durch Eintauchen in heißes Wasser verdichtet.

Die gereinigte Aluminiumplatte wird mit einem Epoxidharzlack überzogen (ca. 50 $g/m^2$ auf jede Seite) und danach ausgehärtet. Der Isolierlack wird so aufgetragen,

HOECHST  AKTIENGESELLSCHAFT
KALLE  Niederlassung der Hoechst AG

- 16 -

daß auch die Wandungen der Stanzlöcher lückenlos bedeckt sind.

Zur chemischen Metallisierung wird verfahren wie im Beispiel 1.

Die Platte ist nun auf ihrer gesamten Oberfläche einschließlich der Lochwandungen mit einer ununterbrochenen etwa 0,3 $\mu$m dicken Kupferschicht überzogen. Die Verarbeitung zur Schaltung erfolgt wie in Beispiel 1 beschrieben.

Patentansprüche

1. Verfahren zur Herstellung von durchkontaktierten elektrischen Leiterplatten, bei dem eine Platte, ein Band oder eine Schicht aus Isolierstoffmaterial mit Durchkontaktierungslöchern, deren Wandungen mit einer leitfähigen Metallschicht überzogen sind, auf mindestens einer Seite mit einer leitfähigen Metallschicht versehen wird, die Metallschicht bildmäßig abgedeckt wird und die nicht abgedeckten Bereiche der Metallschicht entweder durch Metallablagerung verstärkt oder durch Ätzen entfernt werden, wobei im Fall der Metallablagerung die Abdeckschablone anschließend entfernt wird und die nicht verstärkten Anteile der Metallschicht durch Ätzen entfernt werden, dadurch gekennzeichnet, daß man die Löcher in einem regelmäßigen Muster über die Oberfläche der Platte verteilt anbringt, ihre Wandungen vor dem bildmäßigen Abdecken der Metallschicht metallisiert und die Metallschicht und einen Teil der Löcher in der Weise abdeckt, daß im fertigen Produkt nur der gewünschte Anteil aller Löcher als Leitkontakt wirksam wird.

2. Verfahren nach Anspruch 1, dadurch gekennzeichnet, daß beide Seiten des Isolierstoffmaterials mit einer leitfähigen Metallschicht überzogen werden.

3. Verfahren nach Anspruch 1, dadurch gekennzeichnet, daß der gewünschte Anteil der Löcher und die gewünschten Leiterzüge der Metallschicht abgedeckt werden und die nicht abgedeckten Bereiche der Metallschicht durch Ätzen entfernt werden.

4. Verfahren nach Anspruch 1, dadurch gekennzeichnet, daß der nicht gewünschte Anteil der Löcher und der Metallschicht abgedeckt wird, die freiliegenden Bereiche durch Metallablagerung verstärkt werden, die Abdeckschablone entfernt und die freigelegten nicht verstärkten Metallbereiche durch Ätzen entfernt werden.

5. Verfahren nach Anspruch 1, dadurch gekennzeichnet, daß man die Platte oder das Band aus Isolierstoffmaterial mit Löchern versieht und danach die gesamte Oberfläche einschließlich aller Lochwandungen mit einem leitfähigen Metallüberzug versieht.

6. Schichtmaterial zur Herstellung durchkontaktierter Leiterplatten, bestehend aus mindestens einer Lage aus Isoliermaterial und mindestens einer ununterbrochenen leitfähigen Metallschicht, das eine Vielzahl von Durchkontaktierungslöchern aufweist, dadurch gekennzeichnet, daß die Durchkontaktierungslöcher in einem regelmäßigen Muster über die Fläche des Schichtmaterials verteilt und an ihren Innenwänden mit einer leitenden Metallschicht überzogen sind.

HOECHST AKTIENGESELLSCHAFT
KALLE Niederlassung der Hoechst AG

- 19 -

7. Schichtmaterial nach Anspruch 6, dadurch gekennzeichnet, daß die Metallschicht aus Kupfer besteht.

8. Schichtmaterial nach Anspruch 6, dadurch gekennzeichnet, daß die Metallschicht aus Nickel besteht.

9. Schichtmaterial nach Anspruch 6, dadurch gekennzeichnet, daß die Metallschicht eine Stärke von 0,1 - 100 $\mu$m hat.

10. Schichtmaterial nach Anspruch 6, dadurch gekennzeichnet, daß es auf beiden Seiten der Isolierschicht eine Metallschicht trägt und daß die Metallschichten durch die metallisierten Lochwandungen miteinander leitend verbunden sind.